# EUROPEAN PATENT SPECIFICATION

(11) **EP 3 121 923 B1**
(45) Date of publication and mention of the grant of the patent: **04.08.2021**
(21) Application number: 16176186.1
(22) Date of filing: 24.06.2016
(51) Int. Cl.: H02J 3/32, H02J 7/34

(54) **METHOD AND STORAGE UNIT OF ELECTRICAL ENERGY FOR ELECTRICAL POWER SUPPLY TO A NODE OF AN ELECTRICAL NETWORK**
VERFAHREN UND SPEICHEREINHEIT FÜR ELEKTRISCHE ENERGIE ZUR ELEKTRISCHEN ENERGIEVERSORGUNG FÜR EINEN KNOTEN EINES ELEKTRISCHEN NETZES
PROCÉDÉ ET UNITÉ DE STOCKAGE D'ÉNERGIE ÉLECTRIQUE POUR ALIMENTATION ÉLECTRIQUE À UN NOEUD D'UN RÉSEAU ÉLECTRIQUE

(30) Priority: 24.06.2015 US 201514748232
(43) Date of publication of application: 25.01.2017
(73) Proprietor: Hybrid Energy Storage Solutions S.L., 41300 San Jose de la Rinconada (Sevilla) (ES)
(72) Inventor: DOMÍNGUEZ AMARILLO, Eugenio, 41012 Sevilla (ES); MARTÍNEZ VITORIANO, Oliver, 41012 Sevilla (ES); GIL MERA, Isaac, 41927 Mairena del Aljarafe Sevilla (ES); REYES DÍAZ, Manuel Rafael, 41015 Sevilla (ES); MATEO GORDILLO, Cecilia, 41749 El Cuervo de Sevilla (ES); FIGUEROA CUENCA, Miriam, 29130 Alhaurin de la Torre Malaga (ES)
(74) Representative: Clarke Modet & Co.

(56) References cited:
- WO-A1-2012/111234
- US-A1- 2015 127 425
- US-A1- 2015 148 973
- None

## Description

### Technical field

The present invention concerns in general devices and methods for electric power management. In particular, the present invention concerns electrical energy storage units and a method for electric power supply to a power grid node, so as to ensure an optimal energy management of the aforementioned power grid in a decentralized manner.

A power grid is characterized by the needs of the loads that are connected to that power grid and that consume power at any given time. In this context, the power grid condition refers to the operational status of the power grid in its different sections.

### Background of the invention

A paradigm shift in the management of power grids is currently under way. The traditional concept of centralized generation is giving way to new distributed generation grids. The integration of Renewable Energies Sources (RES) into the power grid has played a leading role in this paradigm shift, gaining significance in step with the greater penetration of such energies into the system. However, the presence of this type of generation sources in the power grid has a negative effect on its stability. On the one hand, the power grid becomes more unstable owing to lost inertia. The limited capacity of RES to carry out frequency regulation services, and the fact that they always operate at peak capacity, means that their ability to deal with changes in the needs of the power grid are practically non-existent. On the other hand, the stochastic nature of such sources introduces a degree of uncertainty in the generation system that affects its stability. To reduce these adverse effects, the integration of technologies into the electrical system that allows the power grid to be managed in such a way as to ensure the availability of power and whose dynamic responses contribute inertia to the system is required. Energy storage systems (ESS) meet both these requirements.

There is a wide variety of ESS technologies, however not all of them can be optimally integrated on a large scale to provide electrical services to the power grid, partly because of their high cost, partly because of their power density/energy density ratio and partly because of their useful life.

However, the diversity of the electrical services required makes it unlikely for a single energy storage technology to be able to optimally supply several of these services.

To deal with this circumstance, hybrid energy storage systems (HESS) technology has been developed and currently is recognized as state of the art. The hybridization of different energy storage technologies allows the flexible integration of this type of technology into the power grid, allowing a larger number of energy events to be covered, for longer periods, and with a greater response capacity. This increase in performance is achieved because hybridization allows optimum power density/energy density ratios to be achieved, which translates into greater areas covered within the Ragone plot (Power, Energy). The correct dimensioning and management of this ratio will lead to a lower degradation of the energy storage technologies that make up the HESS, and greater availability of such technologies, allowing an optimal supply of the services to be achieved by permitting high power density and high energy density events to be covered simultaneously over time.

Patent application US-A1-20150142190 discloses a system and method for controlling a power system with an energy generator and a hybrid energy storage system. The system includes two or more energy storage systems, each, as in the present invention, with different energy storage capacities. Also, this patent application includes data developing for one or more control variables refined from expert knowledge, trials and tests; providing the control variables to a fuzzy logic controller and controlling the energy generator and the hybrid energy storage system using the fuzzy logic controller.

Patent US-B2-8364287 discloses a device, a system and a method to manage the generation and use of hybrid electrical power. A monitoring module receives signals from one or more sensors. The signals comprise power level information of an electrical energy storage device, power level information of one or more energy converters, and power level information of an electric load. Furthermore, a determination module compares the signals to determine whether electrical power from the energy converters satisfies the electric load. Finally, a regulation module adjusts the electrical power from the energy converters in response to a determination by the determination module that the electrical power from the energy converters does not satisfy an electric load threshold.

Patent US-B2-7839027 discloses systems, apparatuses and methods for maintaining the state of charge of energy storage devices such as batteries, flywheels, capacitors or other technologies that are energetically coupled with the electricity grid to support ancillary services. To reliably respond to requests to regulate the grid, the charge on the energy storage device is sustained or restored to a specified range in a manner that optimizes the readiness of the energy storage device to supply ancillary services in light of the condition of the grid. A state of charge (SoC) of the energy storage device and the power grid frequency may be monitored. When a request from the operator to regulate the power grid frequency is not being serviced, the charge of the energy storage device may be increased or decreased so that the charge may be sustained within the specific range. Once the SoC falls outside of the first range, charge may be added to or removed from the energy storage device when the power grid frequency has appropriate values, e.g. if the power grid frequency is respectively above a first set point or below a second set point.

Patent US-B2-8946929 discloses a method and apparatus for effectively using energy storage components within a microgrid based on the precalculated SoC and State of Health (SoH) of the energy storage elements in conditions of dynamic charge or discharge.

Patent US-B2-8698351 discloses a system for managing a power system with a plurality of power components that includes power source components and power consumption components including a central power bus, a plurality of connectors electrically adaptable to a power component and to the central power bus, and a control processor that receives the state of each power component from the respective adaptable connector and is configured to balance the voltage and current output from each power source component to provide a desired power to a power consumption component based on the received states.

Other systems for managing power supply to power grid and for monitoring the State of Health of battery assemblies are known from US 2015/148973 and WO 2012/111234.

Finally, patent applications US20140350877, US20140244193, US20130138369, US20140210418, US20130006455 or US20140236511 disclose different methods and systems for calculating the SoC and/or the SoH of energy storage devices such as batteries.

Therefore, there is a need in the field of devices and methods for electric power management for a new energy storage unit (or device), and methods, that are capable of supplying electricity services to the power grid in a simultaneous manner as well as continuously over time, in an optimal fashion, adapting the functional status of the electrical services in real time, and also guaranteeing the stability of the power grid and ensuring the reliability and quality of the supply.

### Description of the invention

An object of the present invention is to provide an energy management technology that allows, considering different present, and/or past, and/or future information, the integration of energy storage systems within a power grid to be optimized in order to meet the different power needs thereof, minimizing the impact on the degradation of the different storage devices that make up the energy storage system. This technology, preferably designed for HESS systems (because of the multiple benefits that these represent) is equally valid for energy storage systems comprised of a single energy storage technology.

The present invention is defined by the appended set of claims and provides, in accordance with a first aspect, a method for the management of electric power supply to a node of a power grid, where a plurality of electrical energy storage devices are used as an electrical energy storage unit (of the same or different types of storage technologies, with the same or different power supply capacities), and that measures, using at least one monitoring device, voltage, current and temperature values of each electrical energy storage device.

Then, a management unit in connection with said monitoring device acquires the measured values and processes them, running a computer algorithm which performs: a first calculation of a degradation state (percentage of the capacity with respect to the nominal capacity, and number of cycles remaining until substitution) of each of the plurality of electrical energy storage devices based on the acquired values; a second calculation of a State of Function (SoF) of the electrical energy storage unit for supplying an electrical service, i.e., a supply of electricity to the power grid to meet a particular need thereof (e.g. supply of a number of loads which can be variable in time), based on the results of at least the first calculation and the conditions and/or needs of the power grid for such electrical service; and finally, based on the calculated SoF, the management unit determines whether or not an electrical power profile for supplying the electrical service can be supplied by a power electronics unit.

Characteristically, the first and second calculations are performed continuously or cyclically, periodically or non-periodically.

Also, in the proposed method, the SoF is calculated on the basis of a equation for the optimized integration with the power grid and whose objective function is variable, i.e. it will be programmed according to the customer's interests, and whose restrictions vary dynamically depending on the variations in peripheral conditions and external values (price of electrical power, cost of the electrical energy storage technologies, strategy, etc.).

In a preferred exemplary embodiment, in particular when the storage devices comprise different storage technologies, i.e. the storage unit is a hybrid system or HESS, the first calculation of the degradation state of each of the electrical energy storage devices is performed for the electrical energy storage unit as a whole, by means of processing and using individual results for each electrical energy storage device, for example through an extrapolation. In this way, a State of Health (SoH) of the electrical energy storage unit can be defined, with the degradation of each of the storage technologies that comprise it. This is of crucial importance when it comes to quantifying the real ratio of power density and energy density of the electrical energy storage unit.

In one exemplary embodiment, the second calculation of the SoF is performed by taking into account the historical use of the electrical energy storage unit and/or a record of predictions of future uses of the power grid. In this case, the cited historical use and the record of predictions of future uses are stored in a memory or database of, or connected to, the management unit for access thereto.

Also, the second calculation of the SoF can be performed for each one of a plurality of electrical services to be provided to, or demanded by, the power grid, or even for combinations thereof based on their compatibility to be developed simultaneously or continuously over time. This plurality of electrical services may be of the same or different types. According to the different functional states calculated, a state of services (SoS) of the electrical energy storage unit is calculated, defining the viability of offering a specific electrical supply (among the plurality of electrical services), at a particular moment in time.

The electrical service or services, to be supplied to the power grid can be performed either at different time intervals, or alternatively, simultaneously, without incurring in this case in a premature degradation of the electrical energy storage devices of the electrical energy storage unit. In a limit case of optimization to reduce degradation, the adequate management of a HESS system based on the two previously submitted calculations ensures less impact in the degradation of the energy storage technologies compared with the use of a non-hybrid system.

In the proposed method, the degradation state is used to calculate a state of charge (SoC) of each of the electrical energy storage devices and of the electrical energy storage unit as a whole, and a state of health (SoH) thereof to obtain a final value of their useful life. In addition, through the SoC and the different parameters of the degradation model, the capacity percentage (%C) of the various electrical energy storage devices and of the electrical energy storage unit is calculated, and compared to their rated values. These calculated parameters of SoC and SoH (%C, number of remaining cycles) can be taken into consideration for the second calculation performed by the algorithm.

When the electrical energy storage unit is a HESS system, it is equally important to know the degradation of the storage unit as a whole as well as that of the technologies comprising it. The thermal and electrical dynamics of a hybrid distributed storage system will vary depending on the ratio of hybridization contemplated, in that a fundamental role in the optimization of those dynamics is played by the degree of penetration of technologies of high power density versus those of high energy density, where it is preferable for the former to be as prominent as possible. In that sense, knowing the degree of degradation of each storage technology compared to the total for the electrical energy storage unit will allow the operation to be adjusted during the second calculation of the SoF. In this way, it can be ensured that the power profile supplied by the electrical energy storage unit, as the sum of the power profiles of each of the technologies comprising it, is optimum based on the degradation suffered by each of the different technologies, avoiding greater rates of degradation and ensuring that the requested power profile on the basis of the present and future conditions of the power grid.

The present invention also includes the calculation of a degradation state of the power electronics unit/s based on the parameters calculated in that respect. These parameters preferably include the hours of use of the unit(s) and/or an indicative value of a reduction in their power.

In a further exemplary embodiment, this power profile is only supplied if the calculated SoF is equal to or greater than a first threshold value, pre-established beforehand, for example by an electrical grid operator. In the event that the calculated SoF is less than this threshold value, the management unit can emit, or send, an alarm signal to a remote computing device to indicate that this power profile has not been supplied to the power grid or that it cannot be supplied.

In yet another exemplary embodiment, the management unit also indicates when any of the electrical energy storage devices must be replaced, for example because their degradation state has exceeded a certain threshold, preferably indicated as a percentage of the rated capacity, and that will be programmable. At the same time, the management unit can advise regarding the dimensioning of the replaced storage device, optimizing it based on existing historical usage and degradation information.

According to a second aspect, the invention also provides an electrical energy storage unit for electric power supply to a power grid node, comprising the following:
- a plurality of electrical energy storage devices (e.g. capacitors, ultra-capacitors, batteries, flywheels, fuel cells etc., of the same or different types of storage technologies, with the same or different power supply capacities, and which are managed as a whole);
- at least one monitoring device for measuring voltage, current and temperature values of the electrical energy storage devices;
- a management unit in connection with the monitoring device for the acquisition and processing of the measured values, by means of one or more processing units, running a computing algorithm; and
- at least one power electronics unit prepared for supplying a power profile to the power grid to provide an electrical service according to a SoF calculated for the electrical energy storage unit.

In particular, the algorithm performs a first calculation, taking into account the acquired values, of a degradation state of each of the electrical energy storage devices (or even of the electrical energy storage unit as a whole, for example when the storage devices that make up the storage unit comprise different energy storage technologies, i.e. a HESS system, processing and using the individual calculated results of the degradation state of each electrical energy storage device), and a second calculation of the SoF to provide the electrical service, on the basis of the results obtained from the first calculation and the conditions or needs of the electrical grid.

In one exemplary embodiment, each electrical energy storage device has an associated power electronics unit.

The conditions of the power grid include its operating parameters (e.g. voltage ranges, frequency, power profile, duration of the electrical service, periodicity of the service, etc.), or the environment (humidity, temperature, weather or environmental conditions, etc.).

In one exemplary embodiment the electrical energy storage unit is portable.

The power profile to be supplied via the power electronics unit may include a continuous electrical current, an alternating electrical current, or both currents for different power grids, that is to manage power grids of a different nature, which may be energetically coupled.

Furthermore, the management unit may include, or have a connection with, a memory or database to store the calculated SoF, as well as all the necessary parameters for its calculation and also the conditions in which the power supply profile has been performed.

Other embodiments of the invention disclosed in this document also include a system for electrical energy storage for electric power supply to a power grid node, the system comprising two or more electrical energy storage units according to the second aspect of the invention, where the management unit is centralized, sharing at least part of its components.

The present invention is of particular significance for the integration and management of distributed power generation sources, for example RES, in the power grid.

The present invention allows the Return of Investment (ROI) of the storage devices to be increased, along with other assets such as the power electronics units comprising them (both own and third-party). Likewise, it allows the CAPEX and OPEX to be reduced (both for own and third-party assets), increasing both the energy availability and the reliability of the invention and the power grid into which it is integrated.

While the present invention presents improvements with regard to the current state of the art in relation to the two previous points, its impact is greater when the invention is applied to a hybrid system or HESS rather than to a single energy storage technology. The possibility of carrying out the provision of grid services simultaneously, continuously over time, and with minimal impact on the degradation of the energy storage technologies is due to the correct management of the HESS system, which is achieved by the algorithms and methodology defined in the present invention.

### Brief description of the drawings

The foregoing and other features and advantages will be more fully understood from the following detailed description of embodiments, which are of a purely illustrative nature and not restrictive, with reference to the accompanying drawings, in which:
Fig. 1 schematically illustrates an exemplary embodiment of the elements included in an electrical energy storage unit or "All in box" device for energy management in a power grid node.
Fig. 2 schematically illustrates another exemplary embodiment of the "All in box" device for the energy management in a power grid node.
Fig. 3 is a block diagram that illustrates an exemplary embodiment of a method for energy management in a power grid node.
Fig. 4 is a block diagram that illustrates another exemplary embodiment of a method for energy management in a power grid node.
Fig. 5 schematically illustrates the different parameters used by the dynamic model according to an exemplary embodiment.
Fig. 6, divided in Fig. 6A and Fig. 6B, illustrates a flow chart with all the logic that can be implemented by the algorithm proposed by the present invention for calculating the SoH of the "All in box" device.

### Detailed description of the invention and examples of embodiments

The present invention consists of an energy management technology developed to carry out, in a decentralized way, the optimal management of electrical grids. This decentralization translates into endowing a power node equipped with this technology, with sufficient intelligence or autonomy to allow it to carry out decision-making that will ensure a better performance of the facility and a better ROI of the electrical energy storage devices managed, and even of the power electronics included, maximizing the benefits obtained from their use.

This autonomy occurs within the framework of operation defined by the power grid operator, and is intended to ensure the stability of the electrical grid, allowing a controlled management of loads, flattening the demand curve and allowing the massive integration of distributed generation sources, such as RE sources. It should be pointed out that this autonomy, translated into the availability and flexibility of energy for carrying out the provision of one or more services, is increased when the methodology presented in this invention is applied to a hybrid electrical energy storage system or HESS.

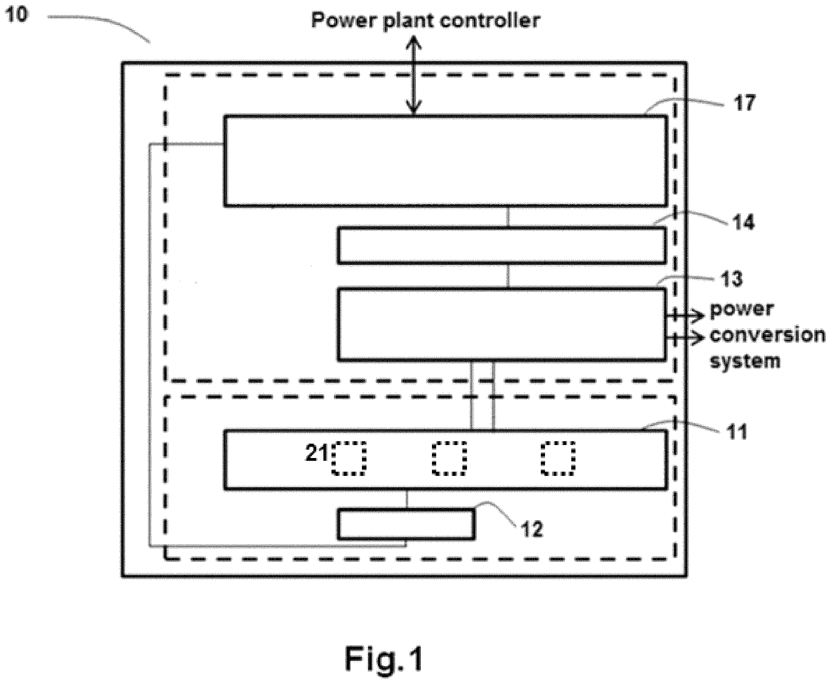

Fig. 1 shows an exemplary embodiment of an electrical energy storage unit or "All in box" device 10 for energy management in a node of the power grid, capable of simultaneously providing electrical services to the electricity grid, allowing its functional status to be adapted in real time. The aforementioned "All in box" device 10, can operate either independently or under instructions submitted by a power grid operator, and according to this exemplary embodiment comprises:
- an electrical energy storage unit 11 with several storage devices 21, of the same or different type of storage technologies (i.e., a HESS system), such as capacitors, ultra-capacitors, batteries, flywheels, fuel cells etc. In this exemplary embodiment the storage devices 21 are associated with a single monitoring device 12 to measure the voltage, current and temperature values of the storage devices that are subsequently sent to a management unit 17 of the "All in box" device 10;
- the power electronics 13 (with its control hardware 14) necessary for the "All in box" device 10 to develop its management (both in a continuous power grid and alternate power grid, and in both at once). The hardware control unit 14 of the power electronics unit 13 interacts with the management unit 17 to configure an output power profile and also to be able to report to the management unit 17 on the degradation state of the power electronics unit 13; and
- the aforementioned management unit 17 which includes all the necessary electronics to acquire different data and manage and monitor the communications between the different elements/units/assets that make up the "All in box" 10 device, and to run the algorithms required for the energy management.

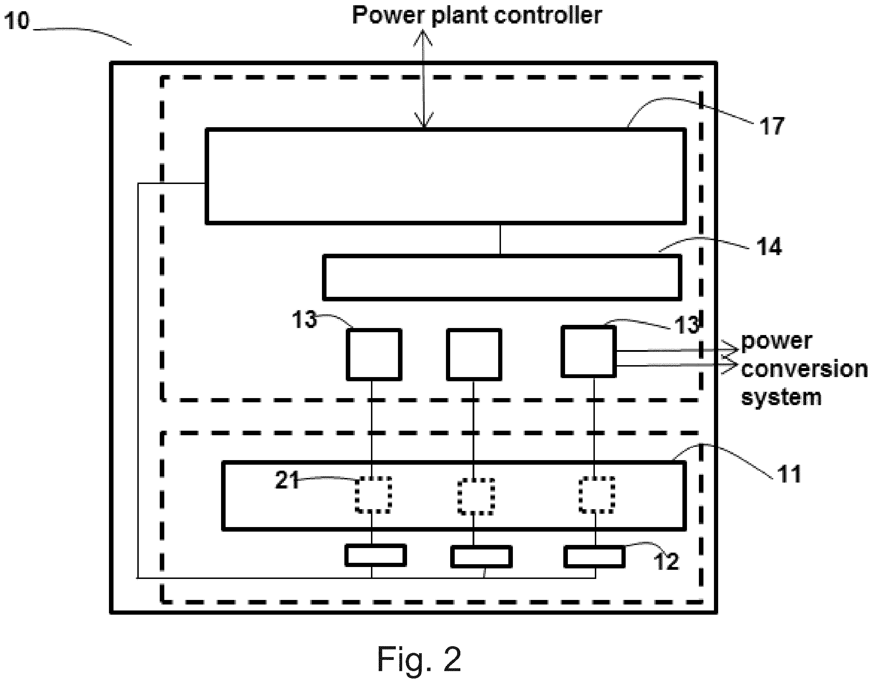

Fig. 2 shows another exemplary embodiment of the "All in box" device 10. In this case, unlike the embodiment shown in Fig. 1, each storage device 21 is associated with a monitoring device 12. Also, each storage device 21 is controlled, individually, by a power electronics unit 13. Although in this embodiment each storage device 21 has an attached monitoring device 12 and power electronics unit 13, this fact is not limitative, since it may occur that some of the storage devices 21 have no associated monitoring device 12 and/or power electronics unit 13, for example when the storage technology of these devices does not require them or is equipped with its own monitoring system, and whereby this technology may be directly monitored from the management unit 17.

At the hardware level, the "All in box" device 10, in either of the exemplary embodiments, may include: a high energy density energy storage system; an energy management system for high energy density ESS; a high power density energy storage system; an energy management system for high power density ESS; a power electronics system (whatever its nature: DC/DC, DC/AC, etc.); a signal acquisition and processing system (physical level of the management unit system 17) and/or at least one hard drive/database system.

At the firmware level, the "All in box" device 10 may include: energy management algorithms for the hybrid system (energy optimization algorithms or algorithms for the simultaneous supply of electrical services to the power grid); dynamic models of the electrical energy storage devices 21 and of the whole unit 11 (dynamic algorithms of the degradation state thereof); dynamic models of the power electronics 13 (dynamic degradation state algorithms); algorithms for the calculation of the SoS of the "All in box" device 10 (SoF of the energy storage devices 21, and the whole unit 11, and even of other device assets such as the power electronics 13), decision algorithms of the state of service (e.g. formation of SoS, optimal detection, transfer of information for defining a set-point of the "All in box" device 10); communication protocols with system/s for generation of energy and/or load systems of energy storage systems; and/or communication protocols with a power grid operator.

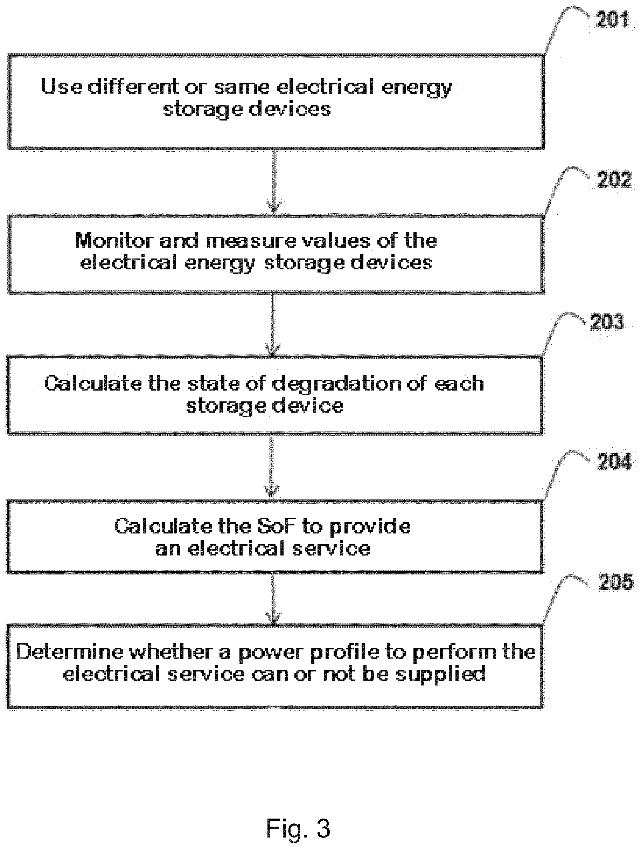

Fig. 3 shows an exemplary embodiment of a method for performing said energy management. The method uses, as an electrical energy storage unit 11, a plurality of electrical energy storage devices 21 (step 201), of the same or different types of storage technologies (HESS). Then, in step 202, certain values are measured, e.g. voltage, current and temperature of the storage devices 21, and from these measured values, a degradation state thereof is calculated (by a computer algorithm) (step 203). Subsequently, in step 204, at least one SoF is calculated for the electrical energy storage unit 11 for supplying at least one electrical service (i.e., a supply of electrical energy to meet a particular need of the power grid). Finally, in step 205, it is determined whether or not a power profile (where the transfer of power that makes up the profile can be absorbed and/or transferred from the power grid) is capable of carrying out the aforementioned electrical service taking into account at least the calculated SoF.

The electrical energy storage devices 21 of the electrical energy storage unit 11 undergo degradation according to their age and use profile. This degradation is quantified by management unit 17, with the "All in box" device 10 adapting its operation on the basis thereof, and thus optimizing their performance and service life in this way. The degradation model concept allows the "All in box" device 10 to adapt in an autonomous and dynamic manner to the different changes that may occur in the boundary conditions of the power grid, either due to the integration of new generation, storage and/or consumption elements, or to changes in the operation thereof or the electrical services that the power grid may require.

This has two primarily implications. On the one hand, if the degradation model in itself contemplates changes in the storage devices 21 owing to their ages and use profiles, it will allow their operation to be adapted based on such variations, increasing the reliability and efficiency of the "All in box" device 10. On the other hand, it will allow the useful life of the electrical energy storage unit 11 to be estimated as a whole and even of the power electronics 13, according to the use made of them. This information will be of great value when it comes to controlling operation and maintenance costs, and to uphold the guarantee of the facilities.

As mentioned previously, the storage devices 21 can be of different types of technologies, in this case forming a HESS system. The hybridization of different storage technologies allows the performance of the electrical energy storage unit 11 to be optimally adapted to the needs of the power grid. Hybridization means the process via which the management of an electrical energy storage unit 11 is carried out and the benefits of which go far beyond the sum of the performance of the types of technologies of which it is comprised. The HESS system is treated as a new unit, whose thermal, electrical and power characteristics are the result of enhancing the main virtues of each type of integrated technology, maximizing benefits and minimizing their weaknesses. The aforementioned dynamic models reach a new level with this concept, since the "All in box" device 10 not only collects models separately from each of the storage devices 21, but also those of the electrical energy storage unit 11 as a whole.

The hybridization of the electrical energy storage unit 11 has a direct effect on the properties of the present invention. Firstly, the set of storage devices 21, preferably with a high energy density and a high power density, enables the "All in box" device 10 to cope with the needs of the various types of power grid systems, and can, in a sustained manner over time supply different electrical services simultaneously. Similarly, the advantages of each of the hybrid storage devices 21, will be used to reduce some of the weaknesses of others. In this way, the operation of the electrical energy storage unit 11 ensures reduced degradation of each of the storage technologies that comprise it, thereby increasing the guarantee of the electrical service. It also gives greater autonomy to the electrical energy storage unit 11 from the point of view of the potentiality of supplying electrical services to the power grid. In addition to increasing the number of services to which they can respond, the availability to implement their supply is also increased.

In certain embodiments, the "All in box" device 10 is equipped to process and manage a large amount of data in order to optimize the energy management it performs. This data may include, according to different exemplary embodiments, both future prediction and past records (historical use record). The correct processing and treatment of the data will give the "All in box" device 10 an overview of the use managed, allowing for traceability (past and future) through which to determine the best configuration for its use and to optimally achieve the requirements defined by the user and the power grid.

The processing of historical data will be one of the main sources of information in the device's dynamic behavior models. Through this processing, the "All in box" device 10 will provide feedback to the dynamic models to enhance their realism and reduce their error margin. This will allow the accuracy to be increased regarding the useful life and current status of the storage devices 21.

The processing of data regarding future predictions will also allow the "All in box" device 10 to optimize its operation. The processing of future data both of the electric company's needs, and of environmental conditions (which may intervene in the patterns of consumption, and of generation (in the case of RES), will enable the "All in box" device 10 to anticipate certain events by configuring its functionality to ensure its future availability, thus reducing the risk of not being able to provide an electrical service or the possible degradation in the supply of the service if it was not prepared for said service.

The "All in box" device 10 also has capacity, through the management unit 17, to distinguish between the feasibility, or not, of providing a particular electrical service to the power grid. The management unit 17 will perform a real-time calculation of the SoF (ability to provide an electrical service) depending on the degradation state of the storage devices 21 (even from the degradation state of the storage unit 11 as a whole if, for example, the invention is applied to a HESS system and/or the degradation of the power electronics 13), of the energy stored, of the electrical services required by the power grid and of the conditions thereof. The SoF depends on the electrical service, and therefore, there will be as many functional states as possible electrical services or combinations thereof that can be supplied. The set of functional states (SoFs) comprise a vector of states or State of Services (SoS), wherein the SoS=[SoF].

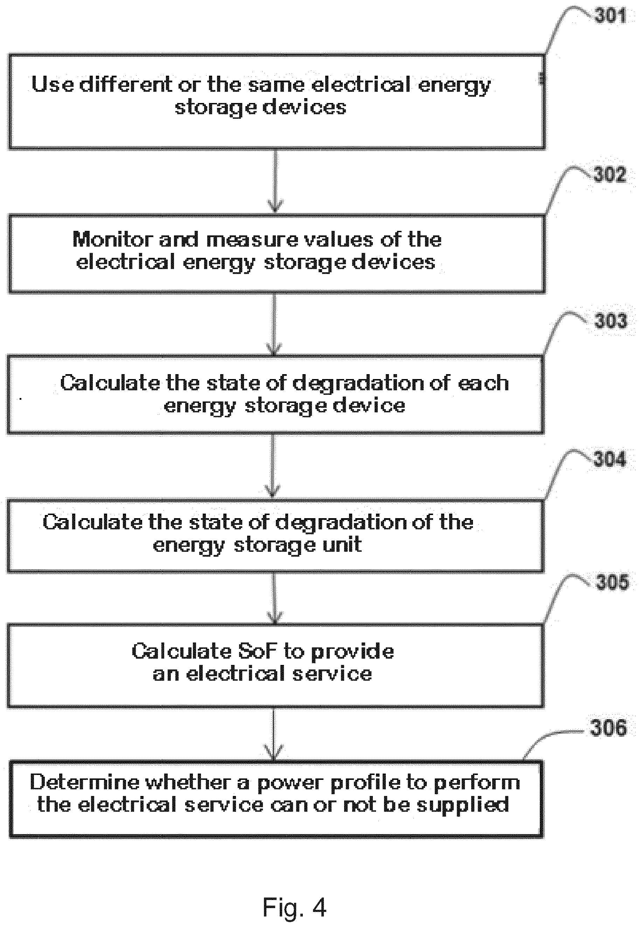

Referring now to Fig. 4, this shows another embodiment of a method to perform energy management in a node of the power grid. In this case, from the electrical energy storage unit 11 and its dynamic degradation model (see Fig. 4) a calculation is performed (step 302) of several values (voltage, temperature, etc.) for each storage device 21 comprising the electrical energy storage unit 11. Once these values are known, they are assessed in order to determine a potential degradation state of the electrical energy storage unit 11 (by extrapolation of the individual results, calculated in step 303) when providing a particular electrical service to the power grid (step 304). Then, in step 305, the estimated SoF of the electrical energy storage unit 11 for providing an electrical service is calculated. Finally, step 306, it is determined whether a power profile (either transferred or absorbed, to or from the power grid) may or may not be provided taking into account at least the SoF calculated.

If electrical service is finally carried out, then the actual calculation of the degradation is performed and the state of the electrical energy storage unit 11 is updated with values relating to its SoC and SoH. From both values, the management unit 17 will know the actual amount of energy available in the electrical energy storage unit 11 (as a percentage of the initial capacity) and the number of cycles remaining in the electrical energy storage unit 11 taking into account the past, current and future uses thereof. This continuous status update allows the status of the electrical energy storage unit 11 to be dynamically monitored (and in consequence the status of the storage devices 21 that comprise it), thus avoiding the uncontrolled degradation of the storage devices 21 from occurring.

Once the actual status of the "All in box" device 10 is known, other parameters may be determined (some unconnected with the device as shown below) such as the capacity and suitability of the "All in box" device 10 to provide a particular electrical service, maximizing the profitability of the storage devices 21 and optimizing the benefits obtained through their use (i.e., the benefits gained according to the objective optimization equation). The calculation of each SoF is resolved by means of a maximum value equation resulting in an index that indicates the degree of feasibility (capacity) of the supply of a particular electrical service.

Owing to the unilateral association of each SoF with a specific electrical service, the "All in box" device 10 must evaluate the different SoF values obtained for the potential electrical services (and possible combinations thereof) that could be covered. The set of these values is recorded in the vector SoS. This vector compiles all the potential functional states of the "All in box" device 10. From the SoS vector, the "All in box" device 10 will be able to determine what electrical service or services (which may be of the same or different type) need to be supplied.

The purpose of developing the dynamic model (Fig. 4) is to know the actual state of the electrical energy storage unit 11 (and the storage devices 21 of which it is comprised). To develop the dynamic model, first a "Beginning of life" (BoL) model is developed for each of the storage devices 21 comprising the electrical energy storage unit 11. The models cover both thermal and electrical characteristics. These models are not innovative from the point of view of the invention, as being those employed in literature and characterized for the storage technologies selected to carry out the hybridization of the electrical energy storage unit 11. This initial BoL model, considers that in all the parameters that make it up, there is no degradation of any kind (the device has not yet been used), and therefore the SoC and SoH status parameters produced by the model show the maximum values. That is to say, an SoC value of 100% and a SoH comprising zero usage cycles, with 100% of the nominal capacity and the maximum number of cycles given by the manufacturer (under conditions similar to those that are expected).

Next, the BoL model is developed for the electrical energy storage unit 11 as a whole. From the models developed beforehand, the model of the hybrid storage unit is defined, treating it as a single energy storage system characterized by a single SoC and SoH value (see Fig 4, 405).

Once the parameters that make up the dynamic model of each of the storage devices 21, and electrical energy storage unit 11 as a whole, are known, an estimate/measurement of them is made. To do this, any of the following techniques can be used: electrochemical impedance spectroscopy (EIS); Equivalent circuit models (ECM): Kalman filters, LMS algorithms and non-recursive filters; and/or electro-chemical models.

From these parameters, via standard estimation and calculation processes, the SoC value is obtained for the electrical energy storage unit 11. Examples of these methods may include: Ah-balancing, OCV (SoC), or Model based estimation.

Once the SoC is calculated, the SoH is calculated (%C, cycles carried out so far, and cycles still remaining of the electrical energy storage unit 11 until its relative capacity drops below a certain threshold value, standardized at 80% although it is programmable/changeable (i.e., it has lost 20% of its factory capacity)). These SoC and SoH parameters (%C and number of cycles remaining), preferably comprise a dynamic parameter, i.e., their values depend on both the current moment (taken from the usage made until that time) and the historical trends or usage patterns. This will allow the "All in box" device 10, through the SoS, to evaluate the feasibility of providing a particular electrical service, not only for the conditions of the power grid and the device 10 when delivering the service, but also of its expectations.

The power electronics 13, while representing a less valuable asset than the storage devices 21, economically speaking, play an equally relevant role from the functional point of view, since without them the energy transfer cannot be performed to the power grid in an optimal manner, nor could the hybridization of storage technologies be contemplated. Therefore, other embodiments (not illustrated) also contemplate the integration of a dynamic model of degradation of the power electronics 13 within the methodology proposed by the present invention, which may be taken into consideration for the second calculation of the SoF. In this way, the degradation state of the power electronics 13 will also be taken into account in the feasibility analysis of providing a specific electrical service supply

The purpose of knowing the degradation of the power electronics 13 is to determine the level of peak power that such electronics could supply based on current conditions, and the present and future needs that may arise in the power grid. In this way the supply can be ensured with the least impact on the electronics.

To carry this out, predictive maintenance techniques will be conducted on the main assets that make up the power electronics 13, detecting any variations in their behavior, which could lead to the calculation of new operating points for the electronics in order to avoid incurring system failures liable to cause power outages.

This level of maintenance will allow the degradation of the power electronics 13 to be monitored and quantified by the power de-rating as a percentage of its rated capacity, and in the hours of life of the most critical power electronics assets. This information will be introduced into the optimization equation required for the calculation of the SoF, adding new information when the feasibility of performing the supply of a particular electrical service is discerned.

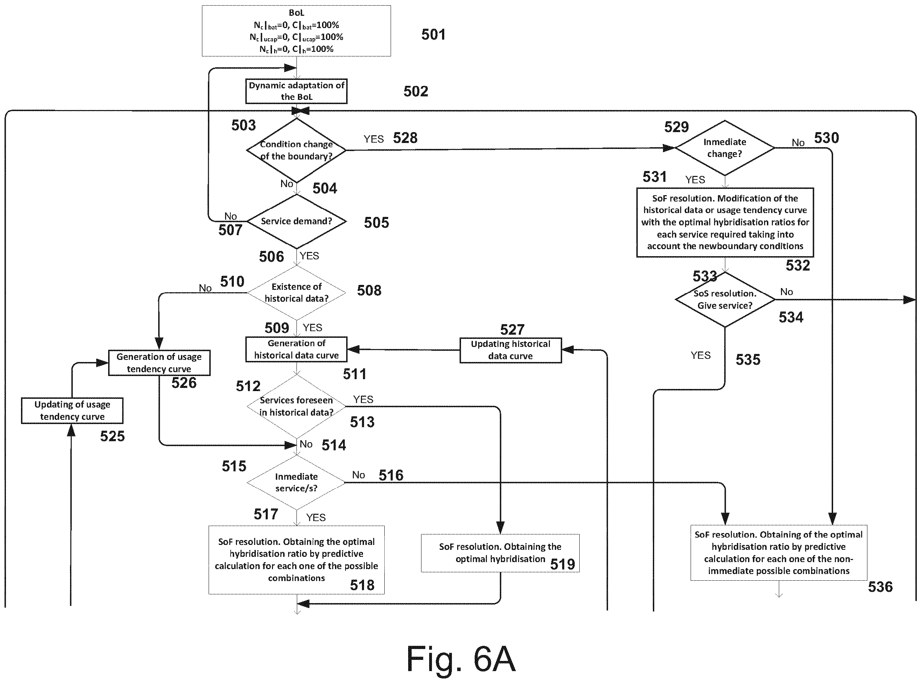

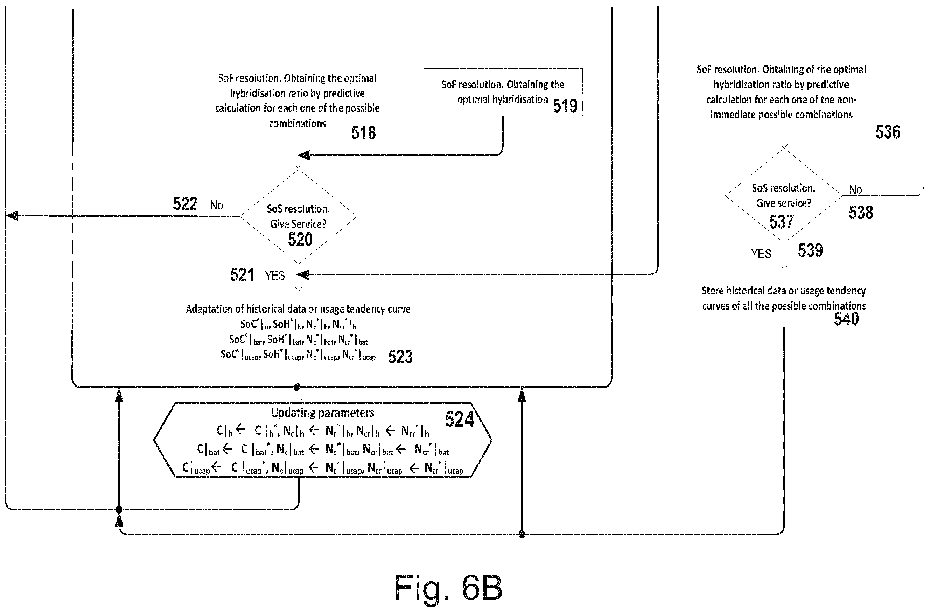

Fig. 6 shows a flowchart that describes all the logic that the method proposed by the present invention can perform, according to different embodiments, for the calculation of the SoH of the electrical energy storage unit 11. The flowchart shows the strong influence of future usage records in the decision-making process (at the present time) of whether or not to perform the supply of a particular electrical service. To do this, from the dynamic model (BoL updated to the present time), the effect on the SoH of performing a particular electrical service is determined. This process, which is developed through the evaluation using techniques to predict future moments, can be approached differently depending on whether or not there are historical usage records of the "All in box" device 10. To simplify the explanation of the process, it will be divided into different steps, and will be examined assuming it has been initialized for the first time, and also, as though the algorithm had already been initialized.

### Algorithm initialization:

1. The starting point of the algorithm is the BoL (501) of the storage devices 21 that make up the electrical energy storage unit 11 (and of the whole of the electrical energy storage unit 11 in the case of a HESS system). The explanation of the algorithm will focus on the degradation models of the electrical energy storage unit 11 (the process is similar, although based on other parameters for the rest of the elements of the "All in box" device 10). Therefore, the algorithm begins with the BoL model of the electrical energy storage unit 11, and each of the technologies that comprise it. This model is based on a maximum values model, i.e., the result of this model is an SoC for each of the storage devices, and of the unit 11 as a whole, associated with 100% of the capacity of the storage devices 21, having undergone zero charge and discharge cycles, with 100% of their nominal capacity and a maximum number of cycles determined experimentally in the laboratory and according to the data provided by the manufacturer. The BoL is therefore the starting point of the dynamic model (502).
2. The condition of changing conditions (503) studies, via hysteresis bands, the possibility that there may be changes in those boundary conditions that could cause changes in the optimal performance of the energy solution defined. During the initialization of the algorithm, there is not yet an active supply of electrical services (507), meaning that variations cannot be contemplated in the algorithm. The process would move on to the next point included in the algorithm (506).
3. The algorithm remains in stand-by (502) waiting for the emergence of the need to supply an electrical service to the power grid (505). This demand can arise, either owing to a necessity indicated by the power grid operator and requested through an instruction or through the transfer of a particular energy profile, or because a need is detected in the power grid by the intelligence capabilities integrated into the "All in box" device 10. This intelligence, can be translated as the autonomy built into the "All in box" device 10 for detecting certain needs of the power grid, assessing the impact both of performing a potential action or not performing it, and acting accordingly.
4. Until an electrical service is requested (506), the algorithm calculates the degradation due to the aging of the storage device 21 and of the electrical energy storage units 11.
5. The first time that a service is requested, the "All in box" device 10 will search its database or memory for the existence of historical data (508) (note that the database or memory may not be included in the "All in box" device 10 itself, particularly the management unit 17, but instead may be remotely linked to the "All in box" device 10). If there is historical data (509), the algorithm traces an estimated usage profile based on this historical data. If there is no historical data (510), a usage trend curve is defined (526), indicating the SoH of the electrical energy storage unit 11 if this was being operated in the same way as required by the electrical service currently demanded. It should be indicated that each of these curves (as appropriate) defines the SoH of each one of the storage devices 21 and of the electrical energy storage unit 11.
6. If the electrical service (or group of electrical services) demanded is registered on the historical data curve (513), its supply will have an implication on the degradation of the electrical energy storage unit 11 that is known in advance (anticipated theoretical degradation). However, since the conditions of delivery may vary from those reflected in the historical data (statistical values), the calculation of the SoF optimization equation is performed and the viability of the supply is validated for the current conditions.
7. The next action taken by the algorithm is to assess whether the electrical supply is required immediately or for predictive purposes (515), (i.e., whether the supply should be performed after its evaluation in the event that it is viable, or whether its effect should be considered for future needs). In either case, this electrical service was not planned according to the historical use (516) meaning that its implications are determined through predictive calculations (536).
   7.1 In the event that the electrical service required must be provided at that time (517), it is performed by carrying out the analysis of the impact of the supply through the feasibility study (resolving the SoF optimization equation for each of the electrical services requested, or even for a combination thereof) 518. The solution of such problems, if any, represents the most optimal manner (not necessarily the most viable, since this is defined by the SoS) for carrying out the transfer of the electrical service. Among the information returned by the resolution of the SoF are the conditions of use of the "All in box" device 10 for the supply of the electrical service.
   7.2 If the electrical service demanded is programmed to be supplied in the future (516), then the manner to proceed to study the feasibility of carrying out the transfer of the electrical service is different, since it should be considered if the supply of other electrical services in the future is contemplated and how the introduction of a new electrical service could affect these.
8. At this point the algorithm decides the viability of the electrical service (520). Once the SoF of the electrical service (or electrical services) is known, the SoS is calculated and the new services to be provided are chosen among those with an SoF that complies with the requirements established by the power grid operator. In the event that no SoF meets these requirements (522) (i.e., they are not superior to a threshold value or first threshold value as detailed above), no electrical services is supplied and the algorithm returns to the standby state (502), awaiting the reception of a new electrical service or changes in the boundary conditions which have already been accepted (503, 505).
9. If there is a solution (521), then changes are made to the usage curve (in the historical usage or in the trend as appropriate) (523).
   9.1 If the change to the curve is caused by an "immediate electrical service" this is the only curve of the system to be taken into account, and will become the new reference curve for the service. In addition, a calculation of the parameters of the "All in box" device 10 is performed, i.e. the estimated %C and Nc is calculated, serving as a new point of departure for the predictive calculations and as an indicator of deviations in the usage curve. Next, the parameters calculated are updated (524), marking a new starting point for sending feedback to the dynamic model of the "All in box" device 10 (502).
   9.2 If the change is caused by a predictive service, then, in addition to the curve resulting from its inclusion, all those curves resulting from the possible scenarios that arise when introducing a new electrical service (525) are saved as references. These references will subsequently be used to determine the impact of changes in the selection of the supplies to be carried out in the future.

### Steps followed by the algorithm once initialized:

1. The last calculation of parameters performed, in the event that the provision of an electrical service has been provided, serves to update the dynamic model (502), serving as a new starting point for determining the degradation of the "All in box" device 10 (i.e. of the electrical energy storage unit 11 and the storage devices 21 that comprise it).
2. The "All in box" device 10 studies the power grid node boundary conditions (503) and detects the existence of relevant changes therein which could involve changes in the optimum energy management values.
   2.1. If there are no changes, the process continues as described in the previous section (504).
   2.2. If there are variations in the boundary conditions (528), a check is performed to see if the changes affect the electrical services which will be provided in the future (predictive) or if they concern the electrical service which is being conducted at the present time (529).
      For changes in the conditions of the current electrical service (531), the effect on the historical curve is the same as when a new electrical service appears for supply to be provided. In other words, new conditions at the present time imply a new degradation trend. The process therefore involves resolving the SoF linked to this new change and using the SoS to evaluate the viability of continuing that supply under these new conditions (532, 533). If it is viable (535), the new usage curve and actual parameters of the "All in box" device 10 will be calculated for the new operating point (523, 524).
      For boundary condition changes in a future electrical service (530), the procedure is not as simple (536), since its variations may involve changes in the viability of the rest of the planned electrical services. In this way, the algorithm contemplates the impact on each of the electrical services already defined, and on their possible combinations (537). As indicated previously, it is very important to store the usage curves for each of the predicting services or combinations thereof. These curves, allow an evaluation to be performed of the effect of a change in a specific electrical service compared to the rest, so that it can be decided whether such changes, depending on the rest of electrical services undertaken, are acceptable (539) or not (538) to the continued provision of the electrical service or if the supply of any of the others must be discontinued (or if their conditions of supply must be modified).
3. If there are no changes in the boundary conditions, the "All in box" device 10 awaits the request for the supply of a new electrical service (505).
4. As in the case of the definition of the usage curve (with data updated according to the previous decisions),
   4.1 Whether the service covered is anticipated in the usage curve (513) or not (514) but its demand is immediate (517), then its SoF is evaluated (518), through the SoS, to verify that it continues to remain viable (520). In the event that this is viable (521), a change is made in the usage curve (523, 525) on the basis of the actual calculation of the degradation parameters; the dynamic model is updated (524) and returns to the start of the algorithm (502).
   4.2 If the electrical service was unforeseen (514) and its demand is not required at the present time (516), then the option of incorporating this forecasting service into the rest of services that might be in the queue is evaluated. To do this, the algorithm evaluates the complete circumstances that such incorporation would imply, seeing how this would affect the rest of the electrical services already planned. The resolution of the different SoF values linked to each of these cases (536) (and possible simultaneities among them), and their evaluation through the SoS (537) brings with it a new optimal scenario where the number and form of electrical services to be covered is decided.
      The algorithm stores (540), (if there is solution of the SoS) the set of curves of each electrical service, or combination thereof, to assess possible future changes in the boundary conditions, and updates the current usage curve (525) with the changes presented by the integration of the new electrical service. Then it skips to the status of waiting for a change in the boundary conditions (503).

The same concept detailed in Fig. 6, depending on other variables and constraints (e.g. hours of use, indicative value of the reduction of the electrical power, etc.) can be applied to define the dynamic model of the other assets/elements that may exist in the "All in box" device 10, as is the case of the power electronics unit(s) 13. In this case the method followed to define the dynamic model of the other elements has not been illustrated to preserve the clarity of the figure.

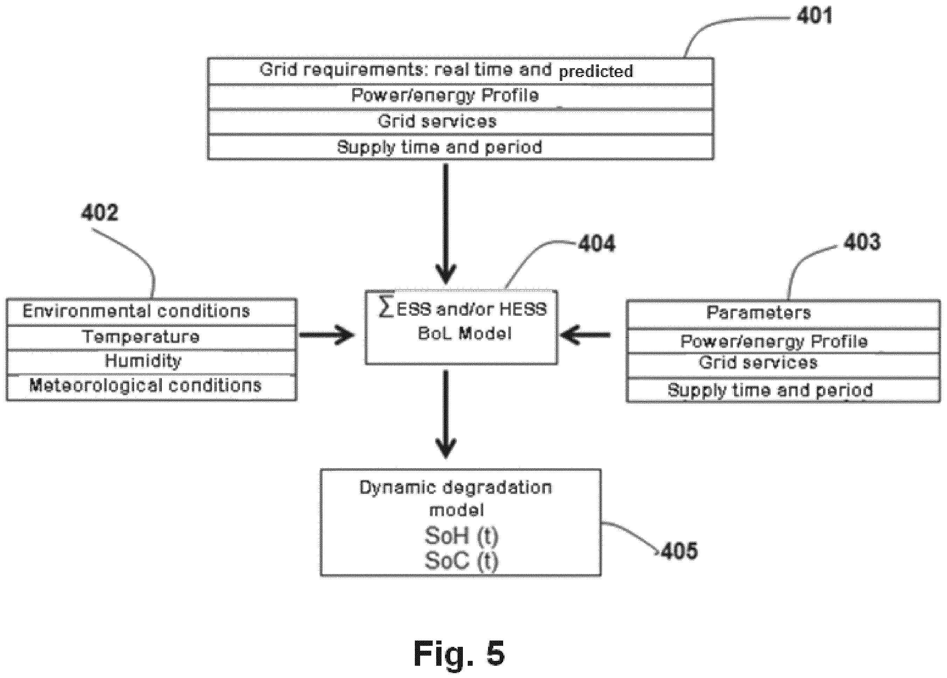

The adaptation process of the dynamic behavior models of the "All in box" device 10 have been described in the previous section according to the usage given to the process and the existing boundary conditions. Fig. 5 shows how the decision-making process regarding whether or not to conduct the supply of an electrical service(s) is based on an analysis of the SoS. This SoS vector expresses the potential of the "All in box" device 10, depending on its current state and future usage expectations, to define the degree of suitability for a particular electrical service to be performed and under what conditions. This degree of suitability is the result of resolving an optimization equation for each SoF.

As already indicated, a SoF is generated for each of the electrical services (and possible combinations thereof). Each SoF contains all the parameters which are relevant when deciding the advantages of supplying a particular electrical service, and therefore contemplates both the internal and external parameters of the "All in box" device 10, also considering both real-time data and future estimates. At the same time, the SoF collects all those restrictions that determine technical, economic and boundary limits, in such a way that the optimal solution sought by the equation-solving process is performed according to the desired criteria.

This equation is resolved for each of the possible electrical services (or combinations thereof) that may be required by the electrical utility company (grid operator) and/or those considered necessary by the autonomous functions (intelligence) of the "All in box" device 10 according to variations in the boundary conditions of the electrical node where it is installed. In any case, the algorithm uses this optimization process to evaluate the degree of suitability of the electrical supply. There may also be various SoS elements with the same value, or otherwise, there may be various closely-grouped maximum values within a specific range. In this case, based on a parameter designated beforehand (for example Revenue from the transfer of the service/ROI of the asset), a new maximum value will be selected. On the other hand, if the values obtained for the different SoF process do not ensure a minimum SoS (use of the aforementioned first threshold value marked by the operator of the device), the supply of the electrical service will not be considered viable.

Finally it should be pointed out how the dynamic characteristic of the invention is also transferred to the optimization equation. The appropriate processing of the information recorded in the database/s using algorithms of a heuristic nature will enable the "All in box" device 10 to learn the impact produced by the supply or not of a type of electrical service on the device and its boundary conditions. This learning process results in changes to the optimization equation (resolution of the SoF), dynamically varying the dimensions of the restrictions comprising it and even changing their structure.

In this way, the "All in box" device 10 will optimize its ability to carry out decisions on the feasibility of whether or not a particular electrical service can be provided, thereby increasing, both the safety and reliability of the device along with the ROI of the storage devices 21.

The proposed invention can be implemented in hardware, software, firmware, or any combination thereof. If implemented as software, the functions can be stored or encoded as one or more instructions or code stored on computer readable media.

Computer readable media include computer storage media. The storage media can be any available media that can be accessed via a computer. By way of example, and not limitation, such a readable computer media may include RAM, ROM, EEPROM, CD-ROM or other optical disk storage, magnetic disk storage, or other magnetic storage devices, or any other means that can be used to carry or store the code of the desired program in the form of instructions or data structures and that can be accessed via a computer. Disk or disc, as used in this document, includes compact discs (CD), laser discs, optical discs, digital versatile disc (DVD), floppy disk and Blu-ray disc whereby disks reproduce normally data magnetically, while discs reproduced data optically with lasers. Combinations of the above should also be included within the scope of computer readable media. Any processor and the storage media can reside on an ASIC - application-specific integrated circuit. ASIC can reside on a user terminal. As an alternative, the processor and the storage media can reside as discrete components in a user terminal.

As used herein, software products that include computer readable media comprehend all forms of medium readable by computer, except to the extent that such media is not deemed to contain unestablished transient propagation signals.

The scope of the present invention is defined in the following set of claims.

## Claims

1. A method for management of electric power supply to a power grid node, the method comprises:
- using a plurality of electrical energy storage devices (21) as an electrical energy storage unit (11);
- measuring in each electrical energy storage device (21), by means of at least one monitoring device (12), voltage, current and temperature values thereof;
- acquiring, by means of a management unit (17) in connection with the monitoring device (12), the values measured by the monitoring device (12) and processing these values by performing, using a computer algorithm, at least a calculation of a degradation state of each electrical energy storage device (21) based on the values acquired and measured, wherein the degradation state of each electrical energy storage device (21) comprises the percentage of the capacity with respect to the nominal capacity and the number of cycles remaining until substitution; and
- determining, by the management unit (17), if a power profile for performing at least one supply of electrical energy to the electrical power grid to satisfy a specific need of the power grid, or electrical service, may or may not be supplied, by at least one power electronics unit (13) associated with the electrical energy storage unit (11) or at least one of the electrical energy storage devices (21),
**characterized in that** the method further comprises:
- calculating a degradation state of the power electronics unit (13) based on parameters calculated thereof, wherein said parameters comprise at least a number of hours of use and/or an indicative value of a reduction in their power;
- processing the values measured by the monitoring device (12) by performing a calculation of a state of function (SoF) of the electrical energy storage unit (11), wherein the state of function (SoF) is an index that indicates the capacity to provide the at least one electrical service, wherein the state of function (SoF) is calculated according to at least one result obtained from:
the degradation state of the electrical energy storage devices (21),
the degradation state of the power electronics unit (13), and
the conditions and/or needs of the power grid for at least one electrical service;
- supplying the power profile if the calculated state of function (SoF) is equal to or greater than a first pre-established threshold value.

2. The method according to Claim 1, wherein the calculation of the degradation state of each electrical energy storage device (21) further comprises calculating a degradation state of the electrical energy storage unit (11) as a whole by means of processing and using the individual results obtained for each electrical energy storage device (21).

3. The method according to Claim 2, comprising performing the calculation of the state of function (SoF) for each of a plurality of electrical services, of the same or different types, and depending on the result obtained from each of the functional states, calculating a state of services (SoS) of the electrical energy storage unit (11) that defines the viability of performing a particular electrical service at a given moment in time.

4. The method according to Claim 3, wherein the calculation of the state of services (SoS) is obtained from:
- an individualized calculation of the state of function (SoF) of each of the electrical services; or
- a calculation including the combination of at least two of said states of function (SoF), most representative in relation to the total power to be supplied; or
- a calculation including the addition of all the states of function (SoF) of each of said electrical services.

5. The method according to Claim 2, wherein the degradation state of the electrical energy storage devices (21) is used to calculate a state of charge (SoC) of each electrical energy storage device (21) and of the electrical energy storage unit (11) as a whole, and to calculate a state of health (SoH) thereof to obtain a final value of their useful life, wherein the calculated state of charge (SoC) and state of health (SoH) are taken into consideration for the calculation of the state of function (SoF).

6. The method according to Claim 2, comprising performing the calculation of the state of function (SoF) in addition to:
- a historical use record of the electrical energy storage unit (11); and/or
- a record of predictions of future uses of the power grid,
wherein said historical use record and said record of predictions of future uses are stored in a memory or database of, or connected to, the management unit (17) for access thereto.

7. The method according to Claim 1, wherein the management unit (17) indicates that an electrical energy storage device (21) must be replaced in the event that the calculated degradation state for said electrical energy storage device (21) exceeds a second pre-established threshold value.

8. The method according to Claim 6, wherein the management unit (17) indicates that an electrical energy storage device (21) must be replaced in the event that the calculated degradation state for said electrical energy storage device (21) exceeds a second pre-established threshold value and indicates the dimensioning of a new electrical energy storage device (21) to be added based on the historical use record and the degradation state.

9. A device (10) for electric power supply to a power grid node, comprising:
- an electrical energy storage unit (11) with a plurality of electrical energy storage devices (21);
- at least one monitoring device (12), associated with one or all the electrical energy storage devices (21), adapted to measure in each electrical energy storage device (21) at least their voltage, current and temperature values;
- a management unit (17) in connection with the monitoring device (12) adapted to the acquisition and processing of the values measured by the monitoring device (12) and their processing by means of one or more processing units running a computing algorithm, wherein the algorithm performs at least a calculation of a degradation state of each electrical energy storage device (21) based on the acquired values, wherein the degradation state of each electrical energy storage device (21) comprises the percentage of the capacity with respect to the nominal capacity and the number of cycles remaining until substitution; and
- at least one power electronics unit (13) associated with the electrical energy storage unit (11) or at least one of the electrical energy storage devices (21), and arranged for supplying a power profile to the power grid to provide an electrical service,
wherein the management unit (17) is configured for determining if a power profile for performing at least one supply of electrical energy to the electrical power grid to satisfy a specific need of the power grid, or electrical service, may or may not be supplied by the at least one power electronics unit (13); **characterized in that** the management unit (17) is further configured for:
- calculating a degradation state of the power electronics unit (13) based on parameters calculated thereof, wherein said parameters comprise at least a number of hours of use and/or an indicative value of a reduction in their power;
- processing the values measured by the monitoring device (12) by performing a calculation of a state of function (SoF) of the electrical energy storage unit (11), wherein the state of function (SoF) is an index that indicates the capacity to provide the at least one electrical service, wherein the state of function (SoF) is calculated according to at least one result obtained from:
the degradation state of the electrical energy storage devices (21),
the degradation state of the power electronics unit (13), and
the conditions and/or needs of the power grid for at least one electrical service;
- supplying the power profile to the power electronics unit (13) if the calculated state of function (SoF) is equal to or greater than a first pre-established threshold value.

10. The device according to Claim 9, wherein the algorithm further performs a calculation of a degradation state of the electrical energy storage unit (11) as a whole, through the processing and use of the results of the calculation of the degradation state for each electrical energy storage device (21), wherein the calculation of the degradation state of the electrical energy storage unit (11) is used to perform the calculation of the state of function (SoF).

11. The device according to Claim 10, wherein the algorithm further performs the calculation of the state of function (SoF) for each of a plurality of electrical services to be supplied to the power grid, of the same or different types, and depending on the result obtained from each of the functional states, calculating a state of services (SoS) of the electrical energy storage unit that defines the viability of performing a particular electrical service at a given moment in time.

12. The device according to Claim 9, comprising a power electronics unit (13) associated to each electrical energy storage device (21).

13. The device according to Claim 9, wherein the conditions of the power grid include its operating parameters, including at least one of: voltage ranges, frequency, power profile, duration of the electrical service, periodicity of the electrical service, or of the environment, including humidity, temperature, weather or environmental conditions.

## Patentansprüche

1. Verfahren zum Verwalten einer elektrischen Energieversorgung für einen Knoten eines elektrischen Netzes, wobei das Verfahren Folgendes umfasst:
- Verwenden einer Vielzahl von elektrischen Energiespeichervorrichtungen (21) als eine elektrische Energiespeichereinheit (11);
- Messen in jeder elektrischen Energiespeichervorrichtung (21) durch mindestens eine Überwachungsvorrichtung (12) von Spannungs-, Strom- und Temperaturwerten davon;
- Erhalten, durch eine Verwaltungseinheit (17) in Verbindung mit der Überwachungsvorrichtung (12), der Werte, die von der Überwachungsvorrichtung (12) gemessen wurden, und Bearbeiten dieser Werte durch Durchführen unter Verwendung eines Computeralgorithmus mindestens einer Berechnung eines Verschlechterungszustands jeder elektrischen Energiespeichervorrichtung (21) basierend auf den Werten, die erhalten und gemessen wurden, wobei der Verschlechterungszustand jeder elektrischen Energiespeichervorrichtung (21) den Prozentanteil der Kapazität bezüglich der Nennkapazität und die Anzahl von Zyklen, die bis zum Austausch verbleiben, umfasst; und
- Bestimmen, durch die Verwaltungseinheit (17), ob ein Energieprofil zum Durchführen mindestens einer Zufuhr von elektrischer Energie zu dem elektrischen Energienetz zum Erfüllen eines bestimmten Bedürfnisses des elektrischen Netzes, oder des elektrischen Dienstes durch mindestens eine Leistungselektronikeinheit (13), die mit der elektrischen Energiespeichereinheit (11) oder mindestens einer der elektrischen Energiespeichervorrichtungen (21) verbunden ist, zugeführt werden kann oder nicht,
**dadurch gekennzeichnet, dass** das Verfahren ferner Folgendes umfasst:
- Berechnen eines Verschlechterungszustands der Leistungselektronikeinheit (13) basierend auf Parametern, die diesbezüglich berechnet wurden, wobei die Parameter mindestens eine Anzahl von Stunden der Nutzung und/oder einen indikativen Wert einer Verringerung ihrer Leistung umfassen;
- Bearbeiten der Werte, die von der Überwachungsvorrichtung (12) gemessen wurden, durch Durchführen einer Berechnung eines Funktionszustands (SoF) der elektrischen Energiespeichereinheit (11), wobei der Funktionszustand (SoF) ein Index ist, der die Kapazität zum Bereitstellen des mindestens einen elektrischen Dienstes angibt, wobei der Funktionszustand (SoF) gemäß mindestens einem Ergebnis berechnet wird, das anhand von Folgendem erhalten wird:
des Verschlechterungszustands der elektrischen Energiespeichervorrichtungen (21),
des Verschlechterungszustands der Leistungselektronikeinheit (13), und
der Bedingungen und/oder Bedürfnisse des elektrischen Netzes für mindestens einen elektrischen Dienst;
- Zuführen des Energieprofils, wenn der berechnete Funktionszustand (SoF) einem ersten vorab festgelegten Schwellenwert entspricht oder größer als dieser ist.

2. Verfahren nach Anspruch 1, wobei die Berechnung des Verschlechterungszustands jeder elektrischen Energiespeichervorrichtung (21) ferner das Berechnen eines Verschlechterungszustands der elektrischen Energiespeichereinheit (11) als Ganzes durch das Bearbeiten und Verwenden der einzelnen Ergebnisse, die für jede elektrische Energiespeichervorrichtung (21) erhalten werden, umfasst.

3. Verfahren nach Anspruch 2, umfassend das Durchführen der Berechnung des Funktionszustands (SoF) für jeden einer Vielzahl von elektrischen Diensten derselben Art oder von verschiedenen Arten, und je nach dem Ergebnis, das von jedem der Funktionszustände erhalten wurde, Berechnen eines Dienstzustands (SoS) der elektrischen Energiespeichereinheit (11), der die Machbarkeit des Durchführens eines bestimmten elektrischen Dienstes zu einem gegebenen Zeitpunkt definiert.

4. Verfahren nach Anspruch 3, wobei die Berechnung des Dienstzustands (SoS) anhand vom Folgendem erhalten wird:
- eine individualisierte Berechnung des Funktionszustands (SoF) jedes der elektrischen Dienste; oder
- eine Berechnung, die die Kombination von mindestens zwei der Funktionszustände (SoF) umfasst, die in Bezug auf die zuzuführende Gesamtleistung am repräsentativsten sind; oder
- eine Berechnung, die das Hinzufügen aller Funktionszustände (SoF) jedes der elektrischen Dienste umfasst.

5. Verfahren nach Anspruch 2, wobei der Verschlechterungszustand der elektrischen Energiespeichervorrichtungen (21) verwendet wird, um einen Ladungszustand (SoC) jeder elektrischen Energiespeichervorrichtung (21) und der elektrischen Energiespeichereinheit (11) als Ganzes zu berechnen und einen Gesundheitszustand (SoH) davon zu berechnen, um einen Endwert ihrer Lebensdauer zu erhalten, wobei der berechnete Ladungszustand (SoC) und der Gesundheitszustand (SoH) für die Berechnung des Funktionszustands (SoF) berücksichtigt werden.

6. Verfahren nach Anspruch 2, umfassend das Durchführen der Berechnung des Funktionszustands (SoF) zusätzlich zu:
- einer historischen Nutzungsaufzeichnung der elektrischen Energiespeichereinheit (11); und/oder
- einer Aufzeichnung von Prognosen zu künftigen Nutzungen des elektrischen Netzes,
wobei die historische Nutzungsaufzeichnung und die Aufzeichnung der Prognose zu künftigen Nutzungen in einem Speicher oder einer Datenbank der Verwaltungseinheit (17) gespeichert oder mit dieser verbunden sind, um darauf zuzugreifen.

7. Verfahren nach Anspruch 1, wobei die Verwaltungseinheit (17) angibt, dass eine elektrische Energiespeichervorrichtung (21) für den Fall, dass der berechnete Verschlechterungszustand für die elektrische Energiespeichervorrichtung (21) einen zweiten vorab festgelegten Schwellenwert überschreitet, ausgetauscht werden muss.

8. Verfahren nach Anspruch 6, wobei die Verwaltungseinheit (17) angibt, dass eine elektrische Energiespeichervorrichtung (21) für den Fall, dass der berechnete Verschlechterungszustand für die elektrische Energiespeichervorrichtung (21) einen zweiten vorab festgelegten Schwellenwert überschreitet, ausgetauscht werden muss, und die Bemessung einer neuen elektrischen Energiespeichervorrichtung (21), die hinzuzufügen ist, basierend auf der historischen Nutzungsaufzeichnung und dem Verschlechterungszustand angibt.

9. Vorrichtung (10) zur elektrischen Energieversorgung für einen Knoten eines elektrischen Netzes, die Folgendes aufweist:
- eine elektrische Energiespeichereinheit (11) mit einer Vielzahl von elektrischen Energiespeichervorrichtungen (21);
- mindestens eine Überwachungsvorrichtung (12), die mit einer oder allen der elektrischen Energiespeichervorrichtungen (21) verbunden ist, die angepasst ist, um in jeder elektrischen Energiespeichervorrichtung (21) mindestens deren Spannungs-, Strom- und Temperaturwerte zu messen;
- eine Verwaltungseinheit (17) in Verbindung mit der Überwachungsvorrichtung (12), die zum Erhalten und Bearbeiten der Werte, die durch die Überwachungsvorrichtung (12) gemessen wurden, und deren Bearbeitung durch eine oder mehrere Bearbeitungseinheiten, die einen Computeralgorithmus ausführen, angepasst ist, wobei der Algorithmus mindestens eine Berechnung eines Verschlechterungszustands jeder elektrischen Energiespeichervorrichtung (21) basierend auf den erhaltenen Werten durchführt, wobei der Verschlechterungszustand jeder elektrischen Energiespeichervorrichtung (21) den Prozentanteil der Kapazität bezüglich der Nennkapazität und die Anzahl an Zyklen, die bis zum Austausch verbleiben, umfasst; und
- mindestens eine Leistungselektronikeinheit (13), die mit der elektrischen Energiespeichereinheit (11) oder mindestens einer der elektrischen Energiespeichervorrichtungen (21) verbunden ist und zum Zuführen eines Energieprofils zu dem elektrischen Netz zum Bereitstellen eines elektrischen Dienstes eingerichtet ist,
wobei die Verwaltungseinheit (17) konfiguriert ist, um zu bestimmen, ob ein Energieprofil zum Durchführen mindestens einer Zufuhr von elektrischer Energie zu dem elektrischen Energienetz zum Erfüllen eines bestimmten Bedürfnisses des elektrischen Netzes oder des elektrischen Dienstes von der mindestens einen Leistungselektronikeinheit (13) zugeführt werden kann oder nicht;
**dadurch gekennzeichnet, dass** die Verwaltungseinheit (17) ferner konfiguriert ist, um:
- einen Verschlechterungszustand der Leistungselektronikeinheit (13) basierend auf Parametern, die diesbezüglich berechnet wurden, zu berechnen, wobei die Parameter mindestens eine Anzahl von Stunden der Nutzung und/oder einen indikativen Wert einer Verringerung ihrer Leistung umfassen;
- die Werte, die von der Überwachungsvorrichtung (12) gemessen wurden, durch Durchführen einer Berechnung eines Funktionszustands (SoF) der elektrischen Energiespeichereinheit (11) zu bearbeiten, wobei der Funktionszustand (SoF) ein Index ist, der die Kapazität zum Bereitstellen des mindestens einen elektrischen Dienstes angibt, wobei der Funktionszustand (SoF) gemäß mindestens einem Ergebnis berechnet wird, das anhand von Folgendem erhalten wird:
des Verschlechterungszustands der elektrischen Energiespeichervorrichtungen (21),
des Verschlechterungszustands der Leistungselektronikeinheit (13), und
der Bedingungen und/oder Bedürfnisse des elektrischen Netzes für mindestens einen elektrischen Dienst;
- Zuführen des Energieprofils zu der Leistungselektronikeinheit (13), wenn der berechnete Funktionszustand (SoF) einem vorab festgelegten Schwellenwert entspricht oder größer als dieser ist.

10. Vorrichtung nach Anspruch 9, wobei der Algorithmus ferner eine Berechnung eines Verschlechterungszustands der elektrischen Energiespeichereinheit (11) als Ganzes durch die Bearbeitung und Verwendung der Ergebnisse der Berechnung des Verschlechterungszustands für jede elektrische Energiespeichervorrichtung (21) durchführt, wobei die Berechnung des Verschlechterungszustands der elektrischen Energiespeichereinheit (11) verwendet wird, um die Berechnung des Funktionszustands (SoF) durchzuführen.

11. Vorrichtung nach Anspruch 10, wobei der Algorithmus ferner die Berechnung des Funktionszustands (SoF) für jeden einer Vielzahl von elektrischen Diensten, die dem elektrischen Netz zuzuführen sind, derselben Art oder von verschiedenen Arten, und je nach dem Ergebnis, das von jedem der Funktionszustände erhalten wird, die Berechnung eines Dienstzustands (SoS) der elektrischen Energiespeichereinheit, der die Machbarkeit des Durchführens eines bestimmten elektrischen Dienstes zu einem gegebenen Zeitpunkt definiert, durchführt.

12. Vorrichtung nach Anspruch 9, die eine Leistungselektronikeinheit (13) aufweist, die mit jeder elektrischen Energiespeichervorrichtung (21) verbunden ist.

13. Vorrichtung nach Anspruch 9, wobei die Bedingungen des elektrischen Netzes seine Betriebsparameter einschließlich mindestens eines der Folgenden umfassen: Spannungsbereiche, Frequenz, Energieprofil, Dauer des elektrischen Dienstes, Regelmäßigkeit des elektrischen Dienstes oder der Umgebung einschließlich Feuchtigkeit, Temperatur, Wetter oder Umgebungsbedingungen.

## Revendications

1. Procédé de gestion de l'alimentation en énergie électrique d'un nœud de réseau électrique, le procédé comprenant :
- l'utilisation d'une pluralité de dispositifs de stockage d'énergie électrique (21) comme unité de stockage d'énergie électrique (11) ;
- mesurer dans chaque dispositif de stockage d'énergie électrique (21), au moyen d'au moins un dispositif de surveillance (12), les valeurs de tension, de courant et de température de celui-ci ;
- acquérir, au moyen d'une unité de gestion (17) en liaison avec le dispositif de surveillance (12), les valeurs mesurées par le dispositif de surveillance (12) et traiter ces valeurs en effectuant, en utilisant un algorithme informatique, au moins un calcul d'un état de dégradation de chaque dispositif de stockage d'énergie électrique (21) sur la base des valeurs acquises et mesurées, dans lequel l'état de dégradation de chaque dispositif de stockage d'énergie électrique (21) comprend le pourcentage de la capacité par rapport à la capacité nominale et le nombre de cycles restant jusqu'au remplacement ; et
- déterminer, par l'unité de gestion (17), si un profil de puissance pour effectuer au moins une fourniture d'énergie électrique au réseau électrique pour satisfaire un besoin spécifique du réseau électrique, ou un service électrique, peut ou ne peut pas être fourni, par au moins une unité électronique de puissance (13) associée à l'unité de stockage d'énergie électrique (11) ou à au moins un des dispositifs de stockage d'énergie électrique (21),
**caractérisé en ce que** la méthode comprend en outre les étapes de :
- le calcul d'un état de dégradation de l'unité électronique de puissance (13) sur la base de paramètres calculés de celle-ci, dans lequel lesdits paramètres comprennent au moins un nombre d'heures d'utilisation et/ou une valeur indicative d'une réduction de leur puissance ;
- traiter les valeurs mesurées par le dispositif de surveillance (12) en effectuant un calcul d'un état de fonctionnement (SoF) de l'unité de stockage d'énergie électrique (11), dans lequel l'état de fonctionnement (SoF) est un indice qui indique la capacité à fournir le au moins un service électrique, dans lequel l'état de fonctionnement (SoF) est calculé selon au moins un résultat obtenu à partir de :
l'état de dégradation des dispositifs de stockage de l'énergie électrique (21),
l'état de dégradation de l'unité d'électronique de puissance (13), et
des conditions et/ou des besoins du réseau électrique pour au moins un service électrique ;
- fournir le profil de puissance si l'état de fonctionnement (SoF) calculé est égal ou supérieur à une première valeur seuil préétablie.

2. Procédé selon la revendication 1, dans lequel le calcul de l'état de dégradation de chaque dispositif de stockage d'énergie électrique (21) comprend en outre le calcul d'un état de dégradation de l'unité de stockage d'énergie électrique (11) dans son ensemble au moyen du traitement et de l'utilisation des résultats individuels obtenus pour chaque dispositif de stockage d'énergie électrique (21).

3. Procédé selon la revendication 2, comprenant la réalisation du calcul de l'état de fonctionnement (SoF) pour chacun d'une pluralité de services électriques, de types identiques ou différents, et en fonction du résultat obtenu à partir de chacun des états de fonctionnement, le calcul d'un état de services (SoS) de l'unité de stockage d'énergie électrique (11) qui définit la viabilité de l'exécution d'un service électrique particulier à un instant donné.

4. Procédé selon la revendication 3, dans lequel le calcul de l'état des services (SoS) est obtenu à partir :
- d'un calcul individualisé de l'état de fonctionnement (SoF) de chacun des services électriques ; ou
- d'un calcul incluant la combinaison d'au moins deux desdits états de fonctionnement (SoF), les plus représentatifs par rapport à la puissance totale à fournir ; ou
- un calcul comportant l'addition de tous les états de fonctionnement (SoF) de chacun desdits services électriques.

5. Procédé selon la revendication 2, dans lequel l'état de dégradation des dispositifs de stockage d'énergie électrique (21) est utilisé pour calculer un état de charge (SoC) de chaque dispositif de stockage d'énergie électrique (21) et de l'unité de stockage d'énergie électrique (11) dans son ensemble, et pour calculer un état de santé (SoH) de ceux-ci afin d'obtenir une valeur finale de leur durée de vie utile, dans lequel l'état de charge (SoC) et l'état de santé (SoH) calculés sont pris en considération pour le calcul de l'état de fonction (SoF).

6. Procédé selon la revendication 2, comprenant la réalisation du calcul de l'état de fonctionnement (SoF) en plus de :
- un historique d'utilisation de l'unité de stockage d'énergie électrique (11) ; et/ou
- un enregistrement de prédictions d'utilisations futures du réseau électrique,
dans lequel ledit enregistrement historique d'utilisation et ledit enregistrement de prédictions d'utilisations futures sont stockés dans une mémoire ou une base de données de l'unité de gestion (17), ou connectés à celle-ci, pour y accéder.

7. Procédé selon la revendication 1, dans lequel l'unité de gestion (17) indique qu'un dispositif de stockage d'énergie électrique (21) doit être remplacé dans le cas où l'état de dégradation calculé pour ledit dispositif de stockage d'énergie électrique (21) dépasse une deuxième valeur seuil préétablie.

8. Procédé selon la revendication 6, dans lequel l'unité de gestion (17) indique qu'un dispositif de stockage d'énergie électrique (21) doit être remplacé dans le cas où l'état de dégradation calculé pour ledit dispositif de stockage d'énergie électrique (21) dépasse une seconde valeur de seuil préétablie et indique le dimensionnement d'un nouveau dispositif de stockage d'énergie électrique (21) à ajouter sur la base de l'historique d'utilisation et de l'état de dégradation.

9. Dispositif (10) pour l'alimentation en énergie électrique d'un nœud de réseau électrique, comprenant :
- une unité de stockage d'énergie électrique (11) avec une pluralité de dispositifs de stockage d'énergie électrique (21) ;
- au moins un dispositif de surveillance (12), associé à un ou tous les dispositifs de stockage d'énergie électrique (21), adapté pour mesurer dans chaque dispositif de stockage d'énergie électrique (21) au moins leurs valeurs de tension, de courant et de température ;
- une unité de gestion (17) en liaison avec le dispositif de surveillance (12) adaptée à l'acquisition et au traitement des valeurs mesurées par le dispositif de surveillance (12) et à leur traitement au moyen d'une ou plusieurs unités de traitement exécutant un algorithme de calcul, dans laquelle l'algorithme effectue au moins un calcul d'un état de dégradation de chaque dispositif de stockage d'énergie électrique (21) sur la base des valeurs acquises, dans laquelle l'état de dégradation de chaque dispositif de stockage d'énergie électrique (21) comprend le pourcentage de la capacité par rapport à la capacité nominale et le nombre de cycles restants jusqu'au remplacement ; et
- au moins une unité d'électronique de puissance (13) associée à l'unité de stockage d'énergie électrique (11) ou à au moins un des dispositifs de stockage d'énergie électrique (21), et agencée pour fournir un profil de puissance au réseau électrique pour fournir un service électrique,
dans lequel l'unité de gestion (17) est configurée pour déterminer si un profil de puissance pour effectuer au moins une fourniture d'énergie électrique au réseau électrique pour satisfaire un besoin spécifique du réseau électrique, ou un service électrique, peut ou ne peut pas être fourni par la au moins une unité d'électronique de puissance (13) ;
**caractérisé en ce que** l'unité de gestion (17) est en outre configurée pour :
- le calcul d'un état de dégradation de l'unité électronique de puissance (13) sur la base de paramètres calculés de celle-ci, dans lequel lesdits paramètres comprennent au moins un nombre d'heures d'utilisation et/ou une valeur indicative d'une réduction de leur puissance ;
- traiter les valeurs mesurées par le dispositif de surveillance (12) en effectuant un calcul d'un état de fonctionnement (SoF) de l'unité de stockage d'énergie électrique (11), dans lequel l'état de fonctionnement (SoF) est un indice qui indique la capacité à fournir le au moins un service électrique, dans lequel l'état de fonctionnement (SoF) est calculé selon au moins un résultat obtenu à partir de :
l'état de dégradation des dispositifs de stockage de l'énergie électrique (21),
l'état de dégradation de l'unité d'électronique de puissance (13), et
des conditions et/ou des besoins du réseau électrique pour au moins un service électrique ;
- fournir le profil de puissance à l'unité électronique de puissance (13) si l'état de fonctionnement (SoF) calculé est égal ou supérieur à une première valeur de seuil préétablie.

10. Dispositif selon la revendication 9, dans lequel l'algorithme effectue en outre un calcul d'un état de dégradation de l'unité de stockage d'énergie électrique (11) dans son ensemble, par le traitement et l'utilisation des résultats du calcul de l'état de dégradation pour chaque dispositif de stockage d'énergie électrique (21), dans lequel le calcul de l'état de dégradation de l'unité de stockage d'énergie électrique (11) est utilisé pour effectuer le calcul de l'état de fonctionnement (SoF).

11. Dispositif selon la revendication 10, dans lequel l'algorithme effectue en outre le calcul de l'état de fonctionnement (SoF) pour chacun d'une pluralité de services électriques à fournir au réseau électrique, de types identiques ou différents, et en fonction du résultat obtenu à partir de chacun des états fonctionnels, le calcul d'un état de services (SoS) de l'unité de stockage d'énergie électrique qui définit la viabilité de l'exécution d'un service électrique particulier à un moment donné dans le temps.

12. Dispositif selon la revendication 9, comprenant une unité d'électronique de puissance (13) associée à chaque dispositif de stockage d'énergie électrique (21).

13. Dispositif selon la revendication 9, dans lequel les conditions du réseau électrique incluent ses paramètres de fonctionnement, incluant au moins l'un des éléments suivants : plages de tension, fréquence, profil de puissance, durée du service électrique, périodicité du service électrique, ou de l'environnement, incluant l'humidité, la température, les conditions météorologiques ou environnementales.
